# EUROPEAN PATENT SPECIFICATION

(11) **EP 1 993 495 B1**
(45) Date of publication and mention of the grant of the patent: **15.07.2020**
(21) Application number: 07713290.0
(22) Date of filing: 01.03.2007
(51) Int. Cl.: G10K 11/178, H05K 7/20

(54) **QUIET ACTIVE FAN FOR SERVERS CHASSIS**
RUHIGER AKTIVER LÜFTER FÜR SERVER-GEHÄUSE
VENTILATEUR ACTIF SILENCIEUX POUR CHÂSSIS DE SERVEURS

(30) Priority: 02.03.2006 US 778090 P; 02.03.2006 US 778091 P; 30.11.2006 US 606019; 30.11.2006 US 606010
(43) Date of publication of application: 26.11.2008
(73) Proprietor: SILENTIUM LTD., Rehovot, 76703 (IL)
(72) Inventor: BARATH, Yossi, 46581 Herzelia (IL); SUROV, Michael, 68077 Tel Aviv (IL); SLAPAK, Alon, 73160 Mazor (IL); ITNATI, Michael, 52560 Ramat Gan (IL)
(74) Representative: Kancelaria Eupatent.pl Sp. z.o.o
(86) International application number: PCT/IL2007/000269
(87) International publication number: WO 2007/099541

(56) References cited:
- EP-A2- 0 615 224
- WO-A1-95/31805
- US-A- 4 665 549
- US-A- 4 665 549
- US-A- 5 377 275
- US-A- 5 636 286
- US-A1- 2002 154 481
- US-A1- 2003 053 635
- US-A1- 2003 123 675
- US-A1- 2005 170 770

## Description

### TECHNICAL FIELD

The disclosure relates to cabinets for mounting electronic equipment (referred to herein as "blade chassis") and, more particularly, to controlling noise generated within a blade chassis.

### BACKGROUND

Noise in general, and tonal noise in particular is very annoying. Low-frequency noise is very penetrating, travels very long distances and is difficult to attenuate using traditional passive control measures.

Passive noise control technology, which usually involves using absorptive materials or noise partitions, enclosures, barriers and silencers, can be bulky, ineffective and rather expensive at low frequencies. Active Noise Control (ANC), on the other hand, can be very efficient and relatively cheaper in reducing low-frequency noise.

Active Noise Control (ANC) is a technology using noise to reduce noise. It is based on the principle of superposition of sound waves. Generally, sound is a wave is travelling in space. If another, second sound wave having the same amplitude but opposite phase to the first sound wave can be created, the first wave can be totally cancelled. The second sound wave is named "antinoise". Although the idea of ANC is not new, its practical application had to wait for the recent development of sufficiently fast electronic control technology. A basic feed-forward active noise control system generally consists of a reference sensor (microphone), an electronic controller, a loudspeaker and an error sensor (microphone), The reference microphone picks up the information of the primary noise field and sends it to the electronic controller; the controller then drives the control loudspeaker to radiate the antinoise; the error microphone examines the control performance and modulates the controller for the best result.

An example of an active noise control system and method may be found in commonly-owned Patent Publication No. WO 2005/027338 ("388"). As shown and described therein, an active noise control (ANC) system may may include an acoustic sensor (typically a microphone) to sense the noise energy and/or wave amplitude of a noise pattern produced by a noise source. The ANC system may also include an acoustic transducer (for example a speaker), and a controller to control the speaker to produce a noise destructive pattern to reduce or cancel the noise energy and/or wave amplitude of the noise pattern, for example within a reduced-noise zone. The controller may include an estimator to produce a predicted noise signal by applying an estimation function to one or more samples of noise signal. A noise error signal may be sensed by a second acoustic sensor (error-sampling microphone) positioned in the reduced-noise zone.

Digital adaptive reduction of noise in the time domain is typically performed by sampling the analog output of a microphone that is appropriately positioned to sense the input noise. The sampled analog noise is then converted to digital format via an AID converter, passed through an adaptive digital filter and then converted back to analog via a D/A converter before being output to a speaker. The analog output of a microphone is utilized as the input to the internal adaptive algorithm within the prior art noise reduction system. A method of noise cancellation used in prior art systems places the microphone as close to the noise source as possible and the loudspeaker relatively far from the microphone so as to create a delay equal to the time for the noise to travel from the microphone to the speaker. This delay is intentionally created in order to match the internal signal processing time of the noise reduction system. The propagation time for the noise is configured to roughly match and compensate for the signal propagation time within the noise reduction system. This noise reduction method is particularly useful for cancellation of noise in a duct such as an air conditioning duct. The internal signal processing is performed during the time that it takes for the sound waves to travel from the microphone to the loudspeaker.

US4665549A "Hybrid active silencer" discloses an acoustic attenuation apparatus is provided for a duct guiding an acoustic wave propagating therethrough. A silencer is provided for passively attenuating the acoustic wave in the duct, and a cancelling speaker is provided within the silencer. The combination provides hybrid active/passive combined attenuation. Various rectangular and circular structures are disclosed, together with multipath and multi-speaker arrangements.

WO9531805A1 describes integration of piezoelectric speaker panels and microphones into a personal computer with a sound card. In addition noise cancellation electronics and algorithms are also applied to enhance performance of a voice recognition system included in the computer.

US5377275A discloses an active noise control apparatus comprising a secondary sound source for generating sound canceling noise emitted from a noise source, first and second microphones sequentially arranged between the noise source and the secondary sound source at a predetermined distance in a direction from the noise source to the secondary sound source, a coefficient multiplier for multiplying an output signal of the second microphone by a coefficient corresponding to a ratio of a transfer function of the first microphone with respect to the secondary sound source to that of the second microphone with respect thereto, a subtracter for obtaining a difference between a multiplication resultant signal and an output signal of the first microphone, and a signal processor for outputting a secondary sound signal obtained by multiplying the difference signal with a predetermined coefficient to the secondary sound source.

Another prior art noise reduction technique is to place the speaker close the noise source rather than far away from it, place a second microphone in the desired quiet zone and to adapt a digital filter utilizing the second microphone output. However, this method is useful for canceling repetitive noise only.

As electric/electronic devices get smaller and functional, the noise of cooling devices becomes important. Inside a desktop computer, there may be three (or more) fans. Usually there is a fan on the heat sink of the CPU, in the rear of the power supply unit, on the case ventilation hole, and maybe on the graphics card, plus one on the motherboard chipset if it is a very recent one. The noise from a computer that annoys people is mostly due to cooling fans if the hard drive(s) is fairly quiet. When Intel Pentium processors were first introduced, there was no need to have a fan on the CPU at all, but most modern CPUs cannot function even for several seconds without a cooling fan, and some CPU's (such as Intel's Prescott core) have extreme cooling requirements, which often causes more and more noise. The type of fan used in a desktop computer is almost always an axial fan, while centrifugal fans are commonly used in laptop computers.

In many cases, for example, in blade chassis, RAID storage devices and the like (referred to herein as blade chassis) the noise level may exceed the level allowed according to the safety standards and regulations and in radical situations may even harm health. The noise emitted from standard fans normally used in blade chassis is characterized by one or several tones, such as at the low frequencies range (<1000Hz). Attempts were made to reduce the noise by passive treatment, for example, IBM 49P2694 Acoustic Attenuation Module. In order to reduce low frequencies range (<1000Hz) by means of passive treatment a substantial weight and size of material must be used. For example, to reduce a tone at 500Hz by about 10 dBA, a muffler of more than 1 meter length and 30 centimeter diameter should be used. The passive means, which are currently being used, are not efficient for reduction of noise at low frequencies, particularly when dealing with fan noise involving airflow which cannot be blocked, without undesirable results (such as heat retention).

### GLOSSARY

Unless otherwise noted, or as may be evident from the context of their usage, any terms, abbreviations, acronyms or scientific symbols and notations used herein are to be given their ordinary meaning in the technical discipline to which the disclosure most nearly pertains. The following terms, abbreviations and acronyms may be used throughout the descriptions presented herein and should generally be given the following meaning unless contradicted or elaborated upon by other descriptions set forth herein. Some of the terms set forth below may be registered trademarks ((R)).
ANC Short for active noise control. ANC is achieved by introducing a canceling "antinoise" wave through an appropriate array of secondary sources. These secondary sources are interconnected through an electronic system using a specific signal processing algorithm for the particular cancellation scheme. ANC is an effective way to attenuate noise that is very difficult and expensive to control using passive means. It has application to a wide variety of problems in manufacturing, industrial operations, and consumer products. See, for example United States Patent 5,377,275.
dB Short for decibel. The decibel (dB) is a measure of the ratio between two quantities, and is used in a wide variety of measurements in acoustics, physics and electronics. While originally only used for power and intensity ratios, it has come to be used more generally in engineering. The decibel is widely used in measurements of the loudness of sound. The decibel unit is commonly used in acoustics to quantify sound levels relative to some 0 dB reference.
dBa Short for decibels adjusted. Weighted absolute noise power, calculated in dB referenced to 3.16 picowatts (-85 dBm), which is 0 dBa.
RAID Short for Redundant Array of Independent Disks. The basic concept underlying RAID is that spreading or "striping" data across multiple hard drives provides three benefits over a large single hard drive: redundancy, higher performance, and greater (and easier) scalability. These benefits are particularly compelling in the server environment, where downtime is very expensive, drive subsystem performance is critical to good server performance, and adding storage capacity is often required. The set of disks across which the data is striped is referred to as an array. The RAID controller hides the individual drives and all the striping and redundancy from the rest of the system. It 'fakes' the system and OS into seeing what looks like a single large drive, which in fact is composed of multiple physical hard drives. RAID controllers can support the creation of multiple composite drives. If one disk fails, the system keeps running by accessing the redundant data on the other disk drives. The failed drive can be removed and replaced ("hot plugged") and the new disk drive is automatically reconstructed by using the information on the remaining drives in the RAID group. All of this can be done without any host, operator, or operating system involvement.
Server A computer on a network that recognizes and responds to client requests for services such as file and print requests or that supports more complex business applications.
Server Blade Built to slide into existing servers, a server blade is a circuit board that contains components on multiple boards.
Modular Modular refers to a system design that is made up of separate components that can be connected. Li a modular design, different components may be added or replaced without affecting the rest of the components in the system.
UPS Abbreviation for Uninterruptible Power Supply (UPS). UPSs use generators and/or batteries to power themselves, keeping them operating during power outages and helping to prevent loss of service for mission critical applications.

### BRIEF DESCRIPTION (SUMMARY)

The present invention provides a server chassis system as defined in independent claim 1. Further advantageous aspects of the invention are defined in the dependent claims.

### BRIEF DESCRIPTION OF THE DRAWINGS

Reference will be made in detail to embodiments of the disclosure, examples of which may be illustrated in the accompanying drawing figures (FIGs.). The figures are intended to be illustrative, not limiting. Although the disclosure is generally described in the context of these embodiments, it should be understood that it is not intended to limit the disclosure to these particular embodiments.

Certain elements in selected ones of the figures may be illustrated not-to-scale for illustrative clarity. Certain ones of the drawings may be stylized for illustrative clarity. For example, an element which is hidden (such as in a perspective view) may be illustrated with solid lines, rather than dashed lines.
**FIG. 1** is a diagram illustrating an ANC system, generally.
**FIG. 2** is a block diagram of an ANC controller, generally, such as for the ANC system of FIG. 1.
**FIG. 3** is a flow chart of a method for reducing the effects of a noise source, as implemented in the ANC controller of FIG. 2.
**FIG. 4** is a diagram of a cabinet for mounting electronic equipment (referred to herein as "blade chassis"), with an active muffler installed to control noise generated within the blade chassis.
**FIG. 5** is a perspective view of an embodiment of an active linear muffler (ALM).
**FIG. 6** is a perspective view of an embodiment of an active angular muffler (AAM).

### DETAILED DESCRIPTION

In the following detailed description, numerous specific details are set forth in order to provide a thorough understanding of the disclosure. However, it will be understood by those skilled in the art that the teachings of the present disclosure may be practiced without these specific details. In other instances, well-known methods, procedures, components and circuits have not been described in detail so as not to obscure the teachings of the present disclosure.

The disclosure relates to reducing noise in a server chassis such as blade server/center chassis by combining passive and active reduction of noise. As used herein, a "blade server" may refer to a housing for a number of individual minimally-packaged computer motherboard "blades" or other noise producing devises, often with vibrating or spinning devices which produce continuous frequencies of noise.

The server chassis system according to the invention comprises an active muffler (a Quiet Active Fan) for reducing noise emitted from a fan and/or a blower in the server chassis.

The active muffler includes active noise reduction means and a controller adapted to reduce the effects of a noise source by sensing the acoustic noise field generated by the noise source and generate an input signal therefrom, generate an acoustic output field that is effective to reduce the level of the acoustic noise field, adjust the input signal generated by an input transducer to compensate for the nonlinear characteristics of the input transducer, remove extraneous signals from the input signal so as to generate a signal corresponding to substantially the noise source alone and generating an anti-noise signal opposite in phase to the input signal, the output actuator means generating the acoustic output field from the anti-noise signal.

The active muffler may be an add-on device, which may be installed in or on or associated with the rear side or other side of the server chassis unit. The active muffler may also be a part of the server chassis. The active muffler provides heat dissipation as by way of air or other fluids suction, convection or conduction (e.g. movement) using one or more blowers and/or fans. The noise, which is emitted from the fan(s)/blower(s), may be reduced by a combination of passive and active treatment. The passive treatment may include barrier and absorbing materials and may be most effective for the frequency range at or above 1000Hz. The active treatment includes Acoustic Noise Control (ANC) and may be most effective for the frequency range at or below 1000Hz.

The active muffler includes one or more fan(s)/blower(s) depending on the heat dissipating or other requirements, which may be controlled as by a thermo-pressure controller. The controller may be adapted to accelerate or decelerate the velocity of the fan(s)/blower(s) according to the thermal and the pressure parameters required to achieve the optimal heat dissipation.

In addition, the active muffler may include passive noise reduction means (for example, barrier materials, absorbing materials, passive construction or any other material known to a person of skill in the art).

### ANC System

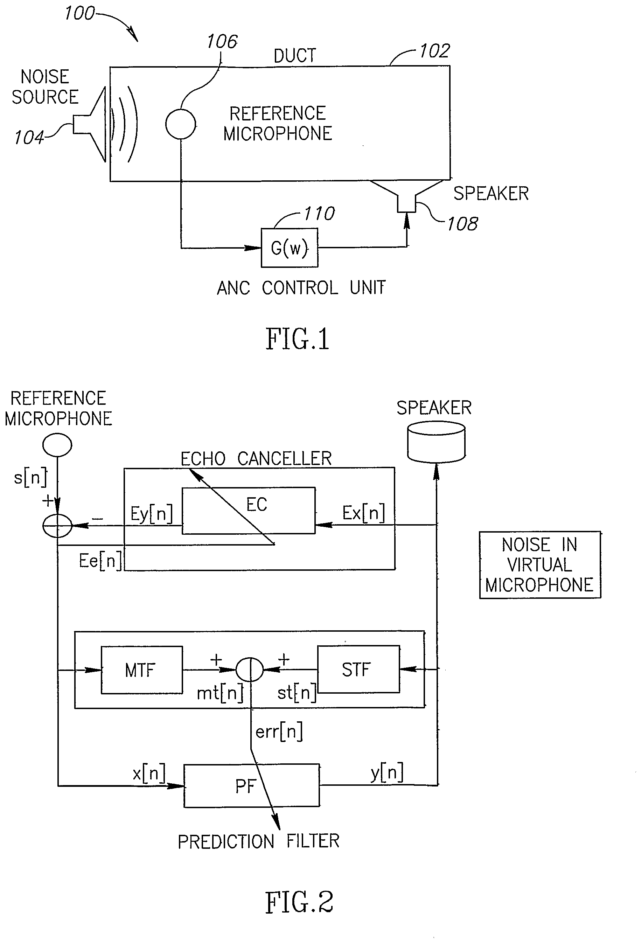

**FIG. 1** illustrates an active noise control (ANC) system 100, generally. The ANC system 100 is shown in conjunction with an elongate, air duct 102 having an inlet end which is open (to the left of the figure) and an outlet end which is open (to the right of the figure). The air duct may 102 may have a round cross-section, or it may have a rectangular cross-section.

Generally, the purpose of the air duct 102 is to convey air from one location to another, from its inlet end to its outlet end. In the context of the present disclosure, the air duct 102 has an additional purpose which is reducing noise which may be emanating from the one location.

A noise source 104 is shown at the inlet end of the air duct 102.

The ANC system 100 includes an acoustic sensor (input transducer, such as a microphone) 106 that receives the noise to be reduced (destructed, suppressed reduced or cancelled). The acoustic sensor 106 may be referred to herein as "reference microphone". The reference microphone 106 may be located anywhere within the duct 102, and may also be located outside of the duct 102.

The ANC system 100 includes an acoustic transducer (output actuator, such as a speaker) 108 that emits destructive (noise-canceling) noise (also referred to as "anti-noise"). The acoustic transducer 108 may be referred to herein simply as "speaker". The speaker 108 may be located anywhere within the duct 102, and may also be located outside of the duct 102.

The ANC system 100 includes a controller (electronic system) 110 which calculates the destructive (noise-canceling) noise to be emitted by the speaker.

Generally, by monitoring the noise from the noise source 104 (using the microphone 106), anti-noise can be calculated by the controller 110 and emitted by the speaker 108 to reduce the noise.

As is known, noise-canceling techniques may include generating anti-noise which is out of phase with the noise generated by the noise source, which can theoretically cancel the noise. Alternatively, anti-noise can be generated which shifts the frequency of the noise being generated by the noise source, such as from a low frequency (such as under 1000 Hz) to a higher frequency (such as over 1000 Hz).

As is known, a second microphone (not shown) can be provided to monitor the results of noise cancellation, at a given, monitored location, and the controller can control the anti-noise which is calculated so that the noise at the monitored location can better be minimized. Such a second microphone is often referred to as "error microphone". One of ordinary skill in the art will recognize this as a control (or feedback) loop situation where a signal is calculated to effect a desired result, the result is monitored, and any deviations from the desired result are taken into account in recalculating the signal so as to better effect the desired result.

Optionally, the controller 110 may also be used to control other instrumentalities which control the temperature and the pressure of the unit.

The Acoustic Noise Control (ANC) system may include an input transducer and an output actuator that are preferably physically located in unitary position, or at least, next to each other in the same location. In one embodiment, the input transducer and the output actuator are a hybrid represented by a single element. The active noise reduction system may be located as close as possible to the noise source as possible and functions to generate the cancellation sound wave with minimum delay with respect to the noise source(s) and minimum reflection or distortion of the noise waveform(s).

The active noise control system, when located very close to the noise source(s), functions to generate synthetic sound waves having a phase preferably opposite that of the noise. Both the noise source and the active noise control system might be situated within an enclosure or may be situated external to an enclosure. In one embodiment, the noise sound wave and the cancellation sound wave spread almost from the same point producing a high amount of noise cancellation. The output power of the cancellation signal is chosen so as to achieve maximum cancellation of the noise sound.

The acoustic cancellation method implemented by the controller may be based on the behavior of acoustic beam patterns in air or other fluids. Cancellation of the noise is achieved in an area far from the noise source while in an area relatively close to the noise source there may be pockets of noise that exist. The length of the quiet zone, as measured from the noise source, is determined by the power of the cancellation signal generated and output by the system. Since the output acoustic beam pattern is dependent on the characteristics of the output actuator and on the main cancellation frequency that is used, the type of output actuator or the angle between a plurality of actuators may need to be varied in order to achieve optimum results for different noise frequencies. The noise reduction method may be capable of achieving effective cancellation of the noise when the surface of the noise source is complex given that the distance from the noise source to the point of cancellation is bigger then the length of the noise source itself.

In addition to sensing sound from the noise source, the system also may detect the sound from the output actuator. The portion of the input signal that is due to the output actuator is removed by using an echo cancellation technique. If the output and input transducers are acoustically separate elements and there exists acoustic delayed feedback in the system, then using an echo cancellation system is advantageous. Another advantage of the echo cancellation system is the elimination of feedback sound emanating from walls, furniture, etc. and sensed by the input transducer. In an example not forming part of the invention, if there is no delayed time feedback from the output transducer to the input transducer and a directional input transducer is used, then a computation may be performed on the input signal, instead of using an echo cancellation system, to discern the actual noise signal from the input signal.

In addition, the cancellation signal (destructive noise) generated by the output actuator may be reflected from the noise source itself thus adding to the amount of noise present. In order to eliminate this type of noise, a delayed cancellation signal is generated by the system. The delay and phase shift applied to the cancellation signal may be matched to the delay and phase shift associated with the reflection and feedback of the sound from the output actuator. Reference is now made to **FIG. 2** which illustrates an ANC controller suitable for the ANC system of FIG. 1, generally.

The abbreviations used herein are short for:
EC, echo cancellation
PF, prediction filter
MTF, reference microphone to error microphone transfer function
STF, speaker to error microphone transfer function

There is therefore provided an acoustic noise control (ANC) system for reducing the effects of a noise source, including input transducer means for sensing the acoustic noise field generated by the noise source and for generating an input signal therefrom, output actuator means for generating an acoustic output field that is effective to reduce the level of the acoustic noise field, correction means for adjusting the input signal generated by the input transducer to compensate for the nonlinear characteristics of the input transducer and output actuator, echo cancellation means for removing from the input signal a portion of the output of the output actuator means feedback through the input transducer means, the output of the echo cancellation means representing a signal preferably corresponding to substantially the noise source by itself, anti-noise means for generating an anti-noise signal opposite in phase to the input signal, the output actuator means generating the acoustic output field from the anti-noise signal and wherein the input transducer means may be located in relatively close proximity to the output actuator means.

The echo cancellation means (Echo Canceller, EC, FIG. 2) may include a digital filter having a delay line with a number of taps whose total delay time is equivalent to at least a system time delay of the noise reduction system, adaptation means for dynamically adjusting the coefficient values associated with each of the taps of the digital filter and summing means for adding the output of the digital filter with the output of the correction means.

The antinoise means comprises the speaker and may include a variable gain amplifier which is located on the electronic board and which is operative to generate an amplified signal 180 degrees opposite in phase from the input signal and gain control means for dynamically controlling the gain of the variable gain amplifier. The gain control means is adapted to receive a manual input control signal from a user which determines the gain of the variable gain amplifier, the user able to vary the location of a quiet zone generated by the system by varying the input control signal. The input control signal is generated by the user remotely from the system and transmitted to the system via wireless communication means.

The system may further include a low pass filter which is located on the electronic board operative to reduce oscillations present in the system derived from feedback of the acoustic output field to the input transducer. Also, the system may further include delay cancellation means as part of the algorithm executed by the controller for reducing the effect of echo signals caused by the anti-noise means sensed by the input transducer. The delay cancellation means may include a plurality of delay cancellation circuits wherein one or more or each delay cancellation circuit is operative to reduce the effect of the echo caused by previous delay cancellation circuits.

A method for reducing the effects of a noise source may include of sensing the acoustic noise field generated by the noise source and for generating an input signal therefrom, generating an acoustic output field that is effective to reduce the level of the acoustic noise field, adjusting the input signal generated by an input transducer to compensate for any non-linear characteristics of the input transducer, removing extraneous signals from the input signal so as to generate a signal corresponding to substantially the noise source alone and generating an anti-noise signal opposite in phase to the input signal, the output actuator means generating the acoustic output field from the anti-noise signal.

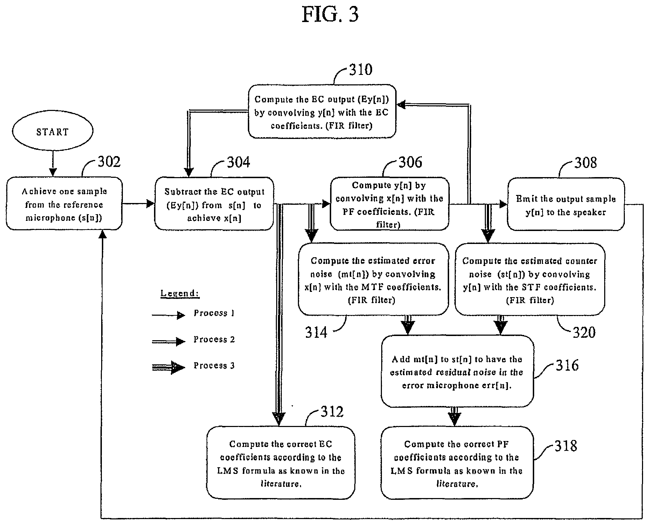

**FIG. 3** illustrates a method for reducing the effects of a noise source. Three processes are illustrated, and are referred to as "Process 1", "Process 2", and "Process 3".

In a first step 302, achieve (acquire) one sample from the reference microphone (s[n]).

In a next step 304, subtract the EC output [Ey[n] from s[n] to achieve x[n].

The first two steps 302 and 304 are common to all three processes (Process 1, Process 2, Process 3).

Next, in Process 1, in a step 306, compute y[n] by convolving x[n] with the PF coefficients (FIR filter).

Next, in Process 1, in a step 308, emit the output sample y[n] to the speaker.

Next, in Process 1, loop back to the step 302 to achieve another sample from the reference microphone.

After the step 306, in Process 2, in a step 310, compute the EC output (Ey[n]) by convolving y[n] with the EC coefficients (FIR filter), and provide the result to step 304, as shown. The purpose of this step is to estimate and to subtract the destructive noise that is sensed by the reference microphone as a surplus signal. The optimal situation is that the reference microphone senses the source signal only, but the real situation is sensing the destructive signal from the speaker also.

Process 3 is different than either of Process 1 or Process 2 in that it does not loop back.

In Process 3, after the step 304, in a step 312, compute the correct EC coefficients according to the LMS formula, as known in the literature. The purpose of this step is to Track changes in time in the transfer function of the speaker and of the space between the speaker and the reference microphone.

In Process 3, also after the step 304, in a step 314, compute the estimated error noise (mt[n]) by convolving x[n] with the MTF coefficients (FIR filter). Then, in a step 316, add mt[n] to st[n] to have the estimated residual noise in the error microphone err[n]. Then, in a step 318, compute the correct PF coefficients according to the LMS formula, as known in the literature. The purpose of these steps is to Track changes in time in the noise signal characteristic and hence to adjust the required destructive noise.

In Process 3, after the step 306, in a step 320, compute the estimated counter noise (st[n]) by convolving s[n] with the STF coefficients (FIR filter). Then, perform the step 316, as already described. The purpose of these steps is to compute the correction of the PF coefficients as per the well known in the literature XLMS algorithm.

There is disclosed herein a noise limiting system (NLS) which incorporates passive means and active (ANC) technology for reducing noise, particularly for use with a blade chassis.

The passive means may be adapted to reduce noise, especially in the frequencies range of >1000Hz, while the ANC system may be adapted to reduce noise, especially in the range of <1000Hz and tones.

The active noise control (ANC) technology may be adapted to achieve up to 10 dBA or more reduction of separated tones, and 5 dBA in a range of frequencies noise.

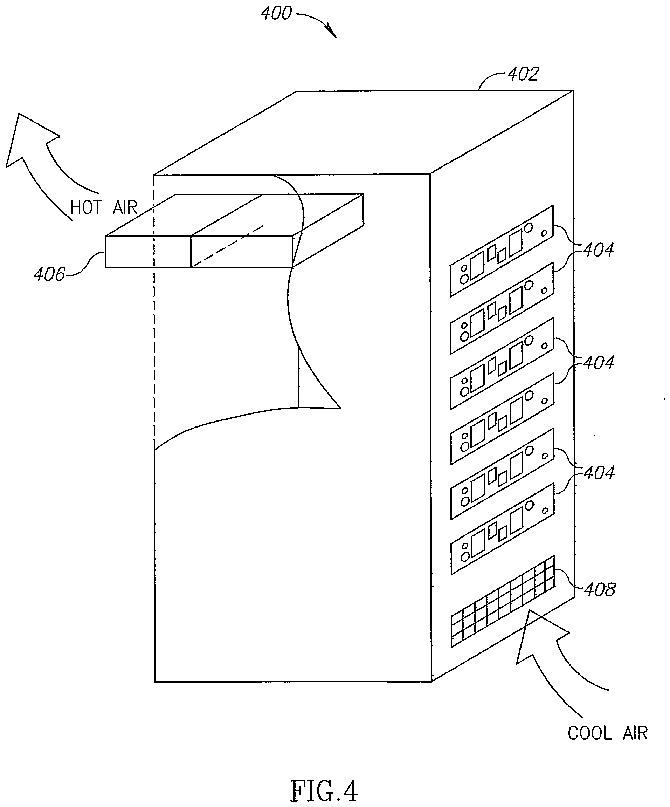

**FIG. 4** illustrates a generic blade chassis 400, comprising a cabinet 402 housing a number electronic units 404 which generate heat, when operating. To reduce the temperature within the cabinet 402, an active muffler 406 is provided to remove hot air from within the cabinet, venting it to the outside. As illustrated, the active muffler 406 extends from within the cabinet 402, to without the cabinet 402, and may be located high on the rear wall of the cabinet. An air inlet 408 on the cabinet admits fresh (presumably cool) air to the cabinet, and may be located low on the front surface of the cabinet.

The active muffler 406 generally comprises a duct within which there is a blower or fan (not shown, described hereinbelow) and may be contructed at least partially of noise-absorbing material, as described hereinbelow. The active muffler 406 may be built in several configurations, for example:

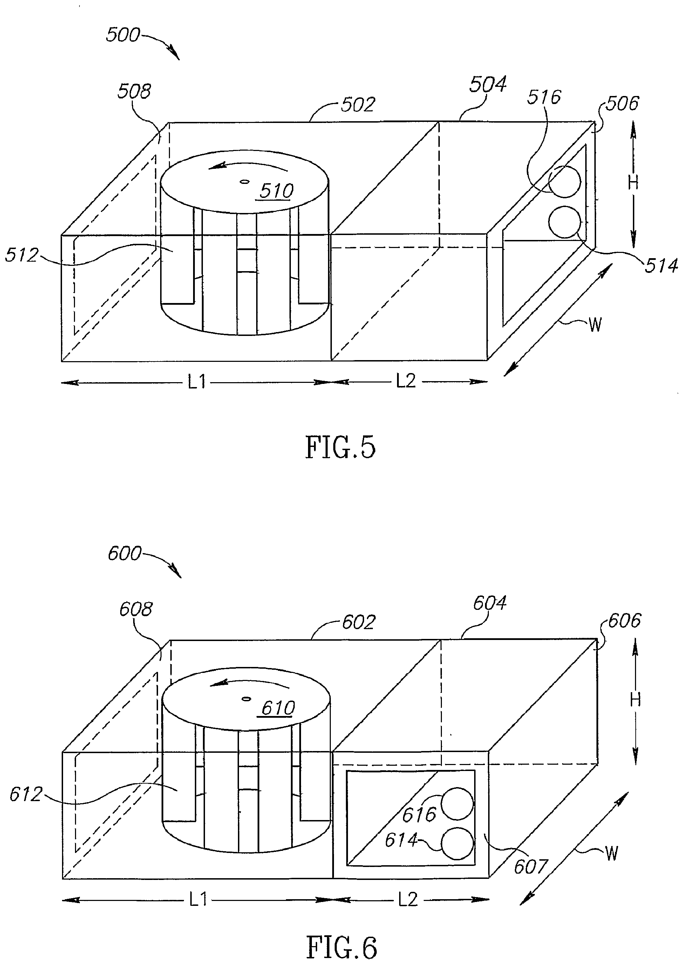

- **FIG. 5** (described in greater detail hereinbelow) illustrates an Active Linear Muffler (ALM), in which the airflow may be directed along a single direction.
- **FIG. 6** (described in greater detail hereinbelow) illustrates an Active Angular Muffler (AAM), in which the airflow may be shifted with one or more angle(s) (such right angle(s)).

In both (ALM, AAM) configurations, a ANC microphone is located in the duct, such as after the blower along the airflow direction, and the speaker may be located at the end of the duct, which exit from the chassis bounds.

The duct may be covered with (or portions of the duct constructed from) one or more absorbing material(s) to reduce noise, especially at the high frequencies (≥1000Hz). The thickness and the type of the absorbing materials may be determined according to the fan/blower's or other parameters.

Thermal sensor(s) may be installed in the duct to provide feedback to the controller (such as a microcontroller, microprocessor logic circuits or the like) regarding the temperature of the outgoing air such that the controller may change the fan/blower's velocity if needed. For example, if the temperature is not too high, the fan speed can be lowered, which may result in less fan noise to be cancelled.
The controller may have a communication channel with the chassis or other apparatus for the sake of mutual indication regarding the operation modes, malfunctioning or any other parameter(s).

Two exemplary configurations of an active muffler 406 will now be described. Generally, both active mufflers which will be described are in the form of a duct having two open ends for conveying air from an inner portion of the duct which may receive warm air from within a cabinet (such as 402) to an outer portion of the duct which vents the warm air to outside the cabinet. Generally, both active mufflers have a fan or blower incorporated in the duct, such as within the inner portion of the duct. Generally, both active mufflers may have a microphone (such as 106) and a speaker (108) incorporated within the duct for working with an ANC control unit (such as 110) which may be located outside of the duct. Generally, both active mufflers may have an inner portion which is formed of a rigid material such as sheet metal or plastic, and may have an outer portion which is formed of a sound-absorbing material which may be reinforced (such as covered by) a more rigid material. Generally, both active mufflers combine passive means such as sound-absorbent material to reduce noise with active means such as an ANC system to further reduce noise, including shifting a frequency of the noise into a range which is better absorbed by the sound-absorbent material.

### Active Linear Muffler (ALM)

**FIG. 5** illustrates an active linear muffler (ALM) 500. Generally, the Active Linear Muffler (ALM) 500 may be based on treating noise by passive and/or active means. The ALM may be an add-on part, which may include the following components:
- a blower,
- passive materials to treat noise, especially at or above 1000 Hz,
- an active noise control (ANC) system (such as described hereinabove with respect to **FIG. 2**) to reduce noise, especially at or below 1000 Hz.

The illustrated embodiment of an ALM 500 is generally in the overall form of a rectangular prism comprising a first (or "inside", or "inner") portion 502 which is intended to be disposed within the interior of a rack (or chassis, not shown, compare 402, FIG. 4) and a second (or "outside", or "outer")) portion 404 which is intended to protrude from the rack.

The inner portion 502 is generally in the overall form of a rectangular prism and may have the following dimensions:
- length (L1), approximately 250 mm
- width (W), approximately 205 mm
- height (H), approximately 100 mm

The inner portion may be sized (particularly height and width) to correspond to the size of an air outlet of a cooling unit (fan, blower or vents) of the device (the server).

The outer portion 504 is generally in the overall form of a rectangular prism and may have the following dimensions:
- length (L2), approximately 150 mm
- width (W), approximately 205 mm
- height (H), approximately 100 mm

The inner portion 502 and the outer portion 504 have approximately the same width (W) and height (H), and are aligned lengthwise. The overall length of the ALM 500 may be approximately 400 mm (LI + L2).

A front side (not visible, right as viewed) of the inner portion 502 may be open, and contiguous with a corresponding open rear side (not visible, left as viewed) of the outer portion 504. The inner portion 502 and the outer portion 504 of the ALM 500 are contiguous with one another, in fluid communication with each other, and together comprise a duct (compare 102, 406) for moving air from within a server chassis (see 402) to without the server chassis.

The front side 506 of the outer portion 504 has an "exhaust" opening for exhausting air to the "atmosphere" (the environment external to the rack).

The rear side 508 of the inner portion 502 has an "intake" opening for receiving air from within the chassis. Alternatively, another side (which is neither the rear side or the front side) of the inner portion 502 has (is provided with) the intake opening for receiving air from within the chassis.

A blower (fan) 510 having blower blades 512 is disposed within the inner portion 502, and rotates to move air from the inner portion 502 to the outer portion 504. When the fan 510 is rotating, air is drawn from within the chassis into the inner portion 502, and moved through the outer portion 504 to the atmosphere.

The fan 510 may be an axial fan, in which case the intake opening would be on the back side of the inner portion 502. The fan 510 may be a centrifugal fan, in which case the intake opening would be on the back side of the inner portion 502. Generally, the fan can be any kind of fan or blower.

The inner portion 502 may be made (formed, constructed) of sheet metal, such as 2 mm steel. Plastic is also possible, but may be too stiff. The outer portion 504 may be made (formed, constructed) of a rigid, sound-absorbing material such as 15 mm (thickness) foam (material), covered with a 2 mm steel panel.

A speaker 514 may be mounted within the outer portion 504, near the right side (or exhaust) opening 506 for the purpose of noise-cancellation, as described hereinabove.

A microphone 516 may be mounted within the outer portion 504, near the right side (or exhaust) opening 506 for the purpose of noise-cancellation, as described hereinabove. Alternative locations for the speaker 514 and the microphone 516 would be anywhere in the ALM 500.

The linear configuration of the ALM 500 minimizes breaking the airflow direction(s). The resulting direct, straight line airflow may be of benefit with regard to thermal performance.

Additionally, the relatively short path of the air may reduce the noise reduction performance, relative to the AAM 600, described hereinbelow (because the AAM 600 has a corner resulting in additional length).

### Active Angular Muffler (AAM)

**FIG. 6** illustrates an active angular muffler (AAM) 600. Whereas the inner and outer portions (502, 504) of the ALM 500 are arranged in a linear configuration, in this example of an AAM 600 the inner and outer portions (602, 604) are arranged in an angular configuration.

Generally, the Active Angular Muffler (AAM) 600 may be based on treating noise by passive and/or active means. The AAM may be an add-on part, which may include the following:
- a blower,
- passive materials to treat noise, especially at or above 1000 Hz (instead of >500Hz as prior focused, which is also generally true for the ALM 500),
- an active noise control (ANC) system (such as described hereinabove with respect to **FIG. 2**) to reduce noise, especially at or below 1000 Hz.

The illustrated embodiment of an ALM 600 is generally in the overall form of a rectangular prism comprising a first (or "inside", or "inner") portion 602 which is intended to be disposed within the interior of a rack (or chassis, not shown, compare 402, **FIG. 4**) and a second (or "outside", or "outer") portion 604 which is intended to protrude from the rack.

The inner portion 602 is generally in the overall form of a rectangular prism and may have the following dimensions:
- length (L1), approximately 250 mm
- width (W), approximately 205 mm
- height (H), approximately 100 mm

The inner portion may be sized (particularly height and width) to correspond to the size of an air outlet of a cooling unit (fan, blower or vents) of the device (the server).

The outer portion 604 is generally in the overall form of a rectangular prism and may have the following dimensions:
- length (L2), approximately 150 mm
- width (W), approximately 205 mm
- height (H), approximately 100 mm

The inner portion 602 and the outside portion 604 have approximately the same width (W) and height (H), and are aligned lengthwise. The overall length of the AAM 600 may be approximately 400 mm (L1 + L2).

A front side (not visible, right as viewed) of the inner portion 602 may be open, and contiguous with a corresponding open rear side (not visible, left as viewed) of the outer portion 604. The inner portion 602 and the outer portion 604 of the AAM 600 are contiguous with one another, in fluid communication with each other, and together comprise a duct (compare 102, 406) for moving air from within a server chassis (see 402) to without the server chassis.

A side surface 607 (which is not the front side 606, compare front end 506 of ALM 500) of the outer portion 604 has an "exhaust" opening for exhausting air to the "atmosphere" (the environment external to the rack).

The rear side 608 of the inner portion 602 has an "intake" opening for receiving air from within the chassis. Alternatively, another side (which is neither the rear side or the front side) of the inner portion 602 has (is provided with) the intake opening for receiving air from within the chassis.

A blower (fan) 610 having blower blades 612 is disposed within the inner portion 602, and rotates to move air from the inner portion 602 to the outer portion 604. When the fan 610 is rotating, air is drawn from within the chassis into the inner portion 602, and moved through the outer portion 604 to the atmosphere.

The fan 610 may be an axial fan, in which case the intake opening would be on the back side of the inner portion 602. The fan 610 may be a centrifugal fan, in which case the intake opening would be on the back side of the inner portion 602. Generally, the fan can be any kind of fan or blower.

The inner portion 602 may be made (formed, constructed) of sheet metal, such as 2 mm steel. Plastic is also possible, but may be too stiff. The outer portion 604 may be made (formed, constructed) of a rigid, sound-absorbing material such as 15 mm (thickness) foam (material), covered with a 2 mm steel panel.

A speaker 614 may be mounted within the outer portion 604, near the right side (or exhaust) opening 606 for the purpose of noise-cancellation, as described hereinabove.

A microphone 616 may be mounted within the outer portion 604, near the right side (or exhaust) opening 606 for the purpose of noise-cancellation, as described hereinabove. Alternative locations for the speaker 614 and the microphone 616 would be anywhere in the ALM 500.

Frugality (less amount of) in passive materials (such as foam) may yield small dimensions and cost reduction while having better performance. This is also generally true for the ALM 500.

The Angular (AAM) configuration may yield a better noise reduction than the Linear (ALM) configuration, since the breaking airflow direction may contribute to a non-negligible noise reduction.

The device (Quiet Active Fan, including either ALM or AAM) may be used in several applications, for example applications that are based on air-cooling systems, which are driven by a fan/blower. These applications may include PC cases, servers cases, racks and more (collectively referred to as "chassis").

While a number of exemplary aspects and embodiments have been discussed above, the scope of the present invention is defined by the following appended claims.

## Claims

1. A server chassis system (400) comprising:
a server chassis cabinet (402) configured to maintain one or more server devices (404);
an air inlet (408) to convey air into said server chassis cabinet (402); and
an active muffler (406, 500, 600) configured to remove hot air from within said server chassis cabinet (402), said active muffler (406, 500, 600) comprising:
a duct (502, 504, 602, 604) extending from within an interior of said server chassis cabinet (402) to an exterior of said server chassis cabinet (402), the duct having a first duct portion (502, 602) disposed within the interior of said server chassis cabinet (402), and a second duct portion (504, 604) protruding from said server chassis cabinet (402), wherein the first duct portion (502, 602) and the second duct portion (504, 604) are contiguous with one another;
a fan or a blower (512, 612) disposed within said first duct portion (502, 602) to move air via said duct from the interior of said server chassis cabinet (402) to the exterior of said server chassis cabinet (402); and
an active noise Control (ANC) system (100) to reduce noise through the duct, the ANC system (100) comprising:
a microphone (106, 516, 616) located within said duct to sense a noise pattern and to produce a noise signal corresponding to the sensed noise pattern;
a speaker (108, 514, 614); and
a controller (110) configured to control the speaker (108) to produce a noise destructive pattern according to a control signal, the controller comprising:
an echo canceller configured to produce an echo cancellation output by convolving a sample of said control signal with echo cancellation coefficients;
a subtractor configured to produce an echo-canceled sample by subtracting the echo cancellation output from a noise sample of the sensed noise pattern received from the microphone; and
a prediction filter configured to produce a successive sample of the control signal by convolving the echo-canceled sample with adjustable prediction-filter coefficients, the prediction-filter coefficients being updated based on an estimated residual noise at an error microphone.

2. The server chassis system of claim 1, wherein the controller (102) is further configured to determine the estimated residual noise based on a sum of a first convolution result and a second convolution result, said controller being further configured to determine said first convolution result by convolving the echo-canceled sample with a reference-microphone to error microphone transfer function, and to determine said second convolution result by convolving the a sample of said control signal with a speaker to error microphone transfer function.

3. The server chassis system of claim 1 or 2 comprising a fan/blower controller configured to control a speed of said fan or said blower (512, 612) based on a temperature and/or a pressure within said duct.

4. The server chassis system of claim 3 comprising at least one thermal sensor to sense the temperature within said duct.

5. The server chassis system of claim 4, wherein the fan/blower controller is further configured to receive from the at least one thermal sensor feedback on the temperature and to lower the speed of said fan or said blower when the temperature is not too high.

6. The server chassis system of any one of claims 1-5, wherein said microphone (106, 516, 616) and said speaker (108, 514, 614) are positioned within said second duct portion (504, 604).

7. The server chassis system of any one of claims 1-6, wherein said active muffler (406, 500, 600) is detachable from said server chassis cabinet (402).

8. The server chassis system of claim 7, wherein said server chassis cabinet (402) comprises an air outlet, and wherein said first duct portion (502, 602) has a shape and dimensions fitted to a shape and dimensions of said air outlet.

9. The server chassis system of any one of claims 1-8, wherein said duct comprises a linear duct configured to convey air from an inlet of the first duct portion to an outlet of the second duct portion in a linear manner.

10. The server chassis system of any one of claims 1-8, wherein said duct comprises an angular duct configured to reduce the noise of airflow through said duct, said angular duct being configured to convey air an inlet of the first duct portion to an outlet of the second duct portion in an angular manner.

11. The server chassis system of any one of claims 1-10, wherein the fan or blower (512, 612) comprises an axial fan or blower, or a centrifugal fan or blower.

12. The chassis system of any one of claims 1-11, wherein the duct has an overall form of a rectangular prism.

13. The chassis system of any one of claims 1-12, wherein the active muffler (406, 500, 600) further comprises passive materials to treat noise, especially at or above 1000Hz.

## Patentansprüche

1. Servergehäusesystem (400), umfassend:
einen Servergehäuseschrank (402), der konfiguriert ist, um eine oder mehrere Servervorrichtungen (404) zu halten;
einen Lufteinlass (408), um Luft in den Servergehäuseschrank (402) zu übermitteln; und
einen aktiven Dämpfer (406, 500, 600), der konfiguriert ist, um warme Luft aus dem Servergehäuseschrank (402) zu entfernen, wobei der aktive Dämpfer (406, 500, 600) umfasst:
einen Kanal (502, 504, 602, 604), der sich von einem Inneren des Servergehäuseschranks (402) zu einem Äußeren des Servergehäuseschranks (402) erstreckt, wobei der Kanal einen ersten Kanalabschnitt (502, 602), der im Inneren des Servergehäuseschranks (402) angeordnet ist, und einen zweiten Kanalabschnitt (504, 604), der vom Servergehäuseschrank (402) vorragt, aufweist, wobei der erste Kanalabschnitt (502, 602) und der zweite Kanalabschnitt (504, 604) zusammenhängen;
ein Gebläse oder einen Lüfter (512, 612), das bzw. der im ersten Kanalabschnitt (502, 602) angeordnet ist, um Luft über den Kanal aus dem Inneren des Servergehäuseschranks (402) zum Äußeren des Servergehäuseschranks (402) zu bewegen; und
ein aktives Rauschsteuerungs-(ANC)-System (100), zum Reduzieren von Rauschen durch den Kanal, wobei das ANC-System (100) umfasst:
ein Mikrofon (106, 516, 616), das sich im Kanal befindet, um ein Rauschmuster zu erfassen und ein Rauschsignal zu erzeugen, das dem erfassten Rauschmuster entspricht;
einen Lautsprecher (108, 514, 614); und
eine Steuerung (110), die konfiguriert ist, um den Lautsprecher (108) zu steuern, um ein Rauschzerstörungsmuster entsprechend einem Steuersignal zu erzeugen, wobei die Steuerung umfasst:
einen Echounterdrücker, der konfiguriert ist, um eine Echounterdrückungsausgabe zu erzeugen, indem er eine Abtastung des Steuersignals mit Echounterdrückungskoeffizienten konvolviert;
einen Subtraktor, der konfiguriert ist, um eine echounterdrückte Abtastung durch Subtrahieren der Echounterdrückungsausgabe von einer Rauschabtastung des vom Mikrofon empfangenen erfassten Rauschmusters zu erzeugen; und
ein Vorhersagefilter, das konfiguriert ist, um eine nachfolgende Abtastung des Steuersignals durch Konvolvieren der echounterdrückten Abtastung mit anpassbaren Vorhersagefilterkoeffizienten zu erzeugen, wobei die Vorhersagefilterkoeffizienten basierend auf einem geschätzten Restrauschen an einem Fehlermikrofon aktualisiert werden.

2. Servergehäusesystem nach Anspruch 1, wobei die Steuerung (102) ferner konfiguriert ist, um das geschätzte Restrauschen basierend auf einer Summe eines ersten Konvolutionsergebnisses und eines zweiten Konvolutionsergebnisses zu bestimmen, wobei die Steuerung ferner konfiguriert ist, um das erste Konvolutionsergebnis durch Konvolvieren der echounterdrückten Abtastung mit einem Referenzmikrofon zur Fehlermikrofontransferfunktion zu bestimmen und das zweite Konvolutionsergebnis durch Konvolvieren der Abtastung des Steuersignals mit einem Lautsprecher zur Fehlermikrofontransferfunktion zu bestimmen.

3. Servergehäusesystem nach Anspruch 1 oder 2, umfassend eine Gebläse-/Lüftersteuerung, die konfiguriert ist, um eine Geschwindigkeit des Gebläses bzw. des Lüfters (512, 612) basierend auf einer Temperatur und/oder einem Druck in dem Kanal zu steuern.

4. Servergehäusesystem nach Anspruch 3, umfassend mindestens einen Wärmesensor zum Erfassen der Temperatur in dem Kanal.

5. Servergehäusessystem nach Anspruch 4, wobei die Gebläse-/Lüftersteuerung ferner konfiguriert ist, um von dem mindestens einen Wärmesensor Feedback zur Temperatur zu empfangen und die Geschwindigkeit des Gebläses bzw. des Lüfters zu senken, wenn die Temperatur nicht zu hoch ist.

6. Servergehäusesystem nach einem der Ansprüche 1 bis 5, wobei das Mikrofon (106, 516, 616) und der Lautsprecher (108, 514, 614) in dem zweiten Kanalabschnitt (504, 604) positioniert sind.

7. Servergehäusesystem nach einem der Ansprüche 1 bis 6, wobei der aktive Dämpfer (406, 500, 600) vom Servergehäuseschrank (402) entfernt werden kann.

8. Servergehäusesystem nach Anspruch 7, wobei der Servergehäuseschrank (402) einen Luftauslass umfasst und wobei der erste Kanalabschnitt (502, 602) eine Form und Abmessungen aufweist, die an eine Form und Abmessungen des Luftauslasses angepasst sind.

9. Servergehäusesystem nach einem der Ansprüche 1 bis 8, wobei der Kanal einen linearen Kanal umfasst, der konfiguriert ist, um Luft von einem Einlass des ersten Kanalabschnitts zu einem Auslass des zweiten Kanalabschnitts auf lineare Art und Weise zu übermitteln.

10. Servergehäusesystem nach einem der Ansprüche 1 bis 8, wobei der Kanal einen winkelförmigen Kanal umfasst, der konfiguriert ist, um das Rauschen von Luftstrom durch den Kanal zu reduzieren, wobei der winkelförmige Kanal konfiguriert ist, um Luft von einem Einlass des ersten Kanalabschnitts zu einem Auslass des zweiten Kanalabschnitts auf winkelförmige Art und Weise zu übermitteln.

11. Servergehäusesystem nach einem der Ansprüche 1 bis 10, wobei das Gebläse bzw. der Lüfter (512, 612) ein axiales Gebläse bzw. einen axialen Lüfter umfasst oder ein zentrifugales Gebläse bzw. einen zentrifugalen Lüfter.

12. Gehäusesystem nach einem der Ansprüche 1 bis 11, wobei der Kanal eine Gesamtform eines rechteckigen Prismas aufweist.

13. Gehäusesystem nach einem der Ansprüche 1 bis 12, wobei der aktive Dämpfer (406, 500, 600) ferner passive Materialien zum Behandeln von Rauschen, insbesondere bei oder über 1000 Hz, umfasst.

## Revendications

1. Système de châssis de serveur (400) comprenant :
une armoire de châssis de serveur (402) configurée pour contenir un ou plusieurs dispositifs serveurs (404) ;
une entrée d'air (408) pour introduire de l'air dans ladite armoire de châssis de serveur (402) ; et
un silencieux actif (406, 500, 600) configuré pour extraire l'air chaud de l'intérieur de ladite armoire de châssis de serveur (402), ledit silencieux actif (406, 500, 600) comprenant :
un conduit (502, 504, 602, 604) s'étendant de l'intérieur d'une partie intérieure de ladite armoire de châssis de serveur (402) à une partie extérieure de ladite armoire de châssis de serveur (402), le conduit possédant une première partie de conduit (502, 602) disposée au sein de la partie intérieure de ladite armoire de châssis de serveur (402), et une deuxième partie de conduit (504, 604) saillante de ladite armoire de châssis de serveur (402), la première partie de conduit (502, 602) et la deuxième partie de conduit (504, 604) étant contiguës entre elles ;
une soufflante ou un ventilateur (512, 612) disposé au sein de ladite première partie de conduit (502, 602) pour déplacer de l'air par le biais dudit conduit de l'intérieur de ladite armoire de châssis de serveur (402) à l'extérieur de ladite armoire de châssis de serveur (402) ; et
un système actif de régulation du bruit (ANC) (100) réduisant le bruit dans le conduit, le système ANC (100) comprenant :
un microphone (106, 516, 616) situé au sein dudit conduit pour détecter un profil de bruit et produire un signal sonore correspondant au profil de bruit détecté ;
un haut-parleur (108, 514, 614) ; et
un régulateur (110) configuré pour assurer la régulation du haut-parleur (108) afin qu'il produise un profil d'insonorisation conforme à un signal de régulation, le régulateur comprenant :
un suppresseur d'écho configuré pour produire un signal de suppression d'écho en convolutionnant un échantillon dudit signal de régulation avec des coefficients de suppression d'écho ;
un soustracteur configuré pour produire un échantillon à écho supprimé en soustrayant la sortie de suppression d'écho d'un échantillon de bruit du profil de bruit détecté reçu du microphone ; et
un filtre prédictif configuré pour produire un échantillon successif du signal de régulation en convolutionnant l'échantillon à écho supprimé avec des coefficients ajustables de filtres prédictifs, les coefficients de filtres prédictifs étant actualisés sur la base d'un bruit résiduel estimé à un microphone d'erreur.

2. Système de châssis de serveur selon la revendication 1, le régulateur (102) étant configuré en outre pour déterminer le bruit résiduel estimé sur la base d'une somme d'un résultat de la première convolution et d'un résultat de la deuxième convolution, ledit régulateur étant configuré en outre pour déterminer ledit résultat de la première convolution en convolutionnant l'échantillon à écho supprimé avec une fonction de transfert d'un microphone de référence à un microphone d'erreur, et pour déterminer ledit résultat de la deuxième convolution en convolutionnant l'un échantillon dudit signal de régulation avec une fonction de transfert d'un haut-parleur à un microphone d'erreur.

3. Système de châssis de serveur selon la revendication 1 ou 2, comprenant un régulateur de soufflante/ventilateur configuré pour la régulation d'une vitesse de ladite soufflante ou dudit ventilateur (512, 612) en fonction d'une température et/ou d'une pression au sein dudit conduit.

4. Système de châssis de serveur selon la revendication 3, comprenant au moins un capteur thermique pour détecter la température au sein dudit conduit.

5. Système de châssis de serveur selon la revendication 4, le régulateur de soufflante/ventilateur étant configuré en outre pour recevoir l'au moins une rétroaction du capteur thermique sur la température, et pour baisser la vitesse dudit ventilateur ou de ladite soufflante lorsque la température n'est pas trop élevée.

6. Système de châssis de serveur selon une quelconque des revendications 1 à 5, ledit microphone (106, 516, 616) et ledit haut-parleur (108, 514, 614) étant positionnés au sein de ladite deuxième partie de conduit (504, 604).

7. Système de châssis de serveur selon une quelconque des revendications 1 à 6, ledit silencieux actif (406, 500, 600) étant amovible de ladite armoire du châssis de serveur (402).

8. Système de châssis de serveur selon la revendication 7, ladite armoire du châssis de serveur (402) comprenant une sortie d'air, et la forme et les dimensions de ladite première partie de conduit (502, 602) étant adaptées pour la forme et les dimensions de ladite sortie d'air.

9. Système de châssis de serveur selon une quelconque des revendications 1 à 8, ledit conduit comprenant un conduit linéaire configuré pour transporter l'air d'une entrée de la première partie de conduit à une sortie de la deuxième partie de conduit, de façon linéaire.

10. Système de châssis de serveur selon une quelconque des revendications 1 à 8, ledit conduit comprenant un conduit angulaire configuré pour réduire le bruit d'un écoulement d'air à travers ledit conduit, ledit conduit angulaire étant configuré pour transporter l'air d'une entrée de la première partie de conduit à une sortie de la deuxième partie de conduit, de façon angulaire.

11. Système de châssis de serveur selon une quelconque des revendications 1 à 10, la soufflante ou le ventilateur (512, 612) comprenant une soufflante ou un ventilateur axial, ou une soufflante ou un ventilateur centrifuge.

12. Système de châssis de serveur selon une quelconque des revendications 1 à 11, la forme globale du conduit étant celle d'un prisme rectangulaire.

13. Système de châssis de serveur selon une quelconque des revendications 1 à 12, le silencieux actif (406, 500, 600) comprenant en outre des matériaux passifs pour le traitement du bruit, surtout à 1 000 Hz ou davantage.
